(19)

Europäisches
Patentamt
European
Patent Office
Office européen
des brevets

(11) **EP 4 235 802 A2**

(12) **EUROPEAN PATENT APPLICATION**

(43) Date of publication:
**30.08.2023 Bulletin 2023/35**

(21) Application number: **23175023.3**

(22) Date of filing: **06.10.2015**

(51) International Patent Classification (IPC):
**H01L 29/788** (2006.01)

(52) Cooperative Patent Classification (CPC):
**H01L 29/66833; H01L 29/7881; H10B 43/35;
H10B 43/50**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **15.10.2014 JP 2014211096**

(62) Document number(s) of the earlier application(s) in
accordance with Art. 76 EPC:
**15850701.2 / 3 208 832**

(71) Applicant: **Floadia Corporation
Kodaira-shi, Tokyo 187-0031 (JP)**

(72) Inventors:
• **TANIGUCHI, Yasuhiro
Kodaira-shi Tokyo, 187-0031 (JP)**
• **KAWASHIMA, Yasuhiko
Kodaira-shi Tokyo, 187-0031 (JP)**

• **KASAI, Hideo
Kodaira-shi Tokyo, 187-0031 (JP)**
• **SAKURAI, Ryotaro
Kodaira-shi Tokyo, 187-0031 (JP)**
• **SHINAGAWA, Yutaka
Kodaira-shi Tokyo, 187-0031 (JP)**
• **OKUYAMA, Kosuke
Kodaira-shi Tokyo, 187-0031 (JP)**

(74) Representative: **Bandpay & Greuter
30, rue Notre-Dame des Victoires
75002 Paris (FR)**

Remarks:
This application was filed on 24-05-2023 as a
divisional application to the application mentioned
under INID code 62.

(54) **METHOD FOR PRODUCING SEMICONDUCTOR INTEGRATED CIRCUIT DEVICES, AND
SEMICONDUCTOR INTEGRATED CIRCUIT DEVICE**

(57)    A method for producing a semiconductor integrated circuit device, and a semiconductor integrated circuit device are disclosed. In the method, during a photomask process of forming a logic gate electrode (G5, G6) in a peripheral circuit region (ER2), a surrounding conductive layer (Ga, Gb) in a memory circuit region (ER1) is divided into a first select gate electrode (G2a, G2b) and a second select gate electrode (G3a, G3b) electrically separated from each other. Thus, even when the first select gate electrode (G2a, G2b) and the second select gate electrode (G3a, G3b) are formed to be separately controllable, it is not necessary to perform an extra dedicated photomask process of fabricating only the memory circuit region (ER1), in addition to a conventional dedicated photomask process of fabricating only the memory circuit region, thereby production cost is reduced.

**EP 4 235 802 A2**

**Description**

Technical Field

The present invention relates to a method for producing a semiconductor integrated circuit device, and a semiconductor integrated circuit device.

Background Art

In a conventional memory cell, a sidewall-shaped select gate electrode is disposed on a sidewall of a memory gate electrode through a sidewall spacer made of an insulating member (for example, refer to Patent Literature 1). In another conventional memory cell, a memory gate electrode is disposed between a sidewall-shaped first select gate electrode and a sidewall-shaped second select gate electrode through a sidewall spacer to allow separate control of the first select gate electrode and the second select gate electrode. In such a memory cell, a charge storage layer is provided to a memory gate structure including the memory gate electrode. Data is programmed by injecting charge into the charge storage layer, and erased by removing charge from the charge storage layer.

In the latter memory cell, when charge is injected into the charge storage layer, a low bit voltage is applied to a channel layer below the memory gate structure through a first select gate structure including the first select gate electrode, while a second select gate structure including the second select gate electrode blocks source voltage. In this case, a high memory gate voltage is applied to the memory gate electrode of the memory gate structure, and charge is injected into the charge storage layer by a quantum tunneling effect due to a voltage difference between the bit voltage and the memory gate voltage.

In a semiconductor integrated circuit device in which memory cells each having such a configuration are disposed in a matrix of rows and columns, a memory gate line to which a high memory gate voltage is applied is shared by a plurality of memory cells. Thus, when a high memory gate voltage is applied to the memory gate line to inject charge into the charge storage layer of one memory cell, the high memory gate voltage is applied also to the memory gate electrode of each of the remaining memory cells sharing the memory gate line although no charge is to be injected into the charge storage layers of the remaining memory cells.

In a memory cell in which no charge is to be injected in the charge storage layer, a high bit voltage is applied from a bit line to the channel layer of the memory gate structure through the first select gate structure while the second select gate structure connected to a source line blocks voltage application to the channel layer. Accordingly, a high bit voltage is applied to the channel layer of the memory gate structure in which a high memory gate voltage is applied to the memory gate electrode, leading to a reduced voltage difference between the memory gate electrode and the channel layer. As a result, no quantum tunneling effect occurs and no charge is injected into the charge storage layer.

For a plurality of memory cells disposed in such a matrix of rows and columns, a photolithography technique, which is a typical semiconductor production process, of processing a resist by using a photomask is employed to form, for example, a conductive layer by using the resist and produce the first select gate structure, the second select gate structure, and the memory gate structure.

Citation List

Patent Literature

Patent Literature 1: Japanese Patent Laid-Open No. 2011-129816

Summary of Invention

Technical Problem

Such a semiconductor integrated circuit device includes, in addition to a plurality of memory cells disposed in a matrix of rows and columns, peripheral circuits such as a central processing unit (CPU), an application-specific integrated circuit (ASIC), a sense amplifier, a column decoder, a row decoder, and an input and output circuit. Thus, production of the memory cells disposed in the matrix requires a semiconductor production process of producing the memory cells, in addition to a semiconductor production process of producing the peripheral circuits.

In particular, each memory cell described above has a special configuration in which the first select gate electrode and the second select gate electrode are separately controllable. Accordingly, an extra dedicated photomask process using a photomask dedicated to fabrication of a memory circuit region only is needed in addition to a conventional dedicated photomask process of fabricating a memory circuit region only, which leads to increase in production cost.

The present invention has been made under such circumstances and aims at providing a method for producing a semiconductor integrated circuit device, and a semiconductor integrated circuit device. In the method, even when a first select gate electrode and a second select gate electrode are formed to be separately controllable, it is not necessary to perform an extra dedicated photomask process of fabricating a memory circuit region only, in addition to a conventional dedicated photomask process of fabricating a memory circuit region only, and thereby production cost is reduced accordingly.

Solution to Problem

In order to solve the above-described problems, a method for producing a semiconductor integrated circuit device of the present invention is a method for producing a semiconductor integrated circuit device including a memory circuit region and a peripheral circuit region, the memory circuit region including a memory cell in which a memory gate structure is disposed between a first select gate structure and a second select gate structure through a sidewall spacer, the first select gate structure including a first select gate electrode, the second select gate structure including a second select gate electrode, the peripheral circuit region including a logic gate structure of a peripheral circuit, and includes a sidewall spacer formation step, a conductive layer formation step, a conductive layer patterning step, and a gate electrode formation step. The sidewall spacer formation step forms the memory gate structure in the memory circuit region and then forming a sidewall spacer covering the memory gate structure, the memory gate structure including a lower gate insulating film, a charge storage layer, an upper gate insulating film, and a memory gate electrode stacked in this order. The conductive layer formation step stacks a gate insulating film and a conductive layer in this order in the memory circuit region formed with the memory gate structure and in the peripheral circuit region. The conductive layer patterning step etches back the conductive layer in the memory circuit region while leaving intact the conductive layer in the peripheral circuit region, so as to form a sidewall-shaped surrounding conductive layer around the memory gate electrode and along the sidewall spacer. The gate electrode formation step patterns the conductive layer in the peripheral circuit region by using a resist patterned by using a photomask, so as to form a logic gate electrode of the logic gate structure on the gate insulating film, and removes at least a part of the surrounding conductive layer in the memory circuit region by using the resist, so as to divide the surrounding conductive layer into the first select gate electrode and the second select gate electrode. The second select gate electrode is electrically separated from the first select gate electrode.

A semiconductor integrated circuit device of the present invention includes a memory circuit region and a peripheral circuit region. The memory circuit region includes a memory cell in which the memory gate structure is disposed between the first select gate structure and the second select gate structure through a sidewall spacer. The first select gate structure includes a first select gate electrode. The second select gate structure includes a second select gate electrode. The peripheral circuit region includes a logic gate structure of a peripheral circuit. The logic gate structure has a configuration in which a logic gate electrode made of a conductive layer same as a conductive layer of the first select gate electrode and the second select gate electrode is disposed on a gate insulating film. The memory gate structure has a configuration in which a lower gate insulating film, a charge storage layer, an upper gate insulating film, and a memory gate electrode are stacked in this order. The first select gate electrode and the second select gate electrode are sidewall-shaped along the sidewall spacer on a sidewall of the memory gate electrode, and disposed along one line surrounding the memory gate electrode, and electrically separated from each other by a plurality of select gate electrode cutout portions at which the first select gate electrode and the second select gate electrode are absent.

[Advantageous Effects of Invention]

According to the present invention, during a photomask process of forming a logic gate electrode in a peripheral circuit region, a surrounding conductive layer in a memory circuit region is divided into a first select gate electrode and a second select gate electrode electrically separated from each other. Thus, when the first select gate electrode and the second select gate electrode are formed to be separately controllable, an extra dedicated photomask process of fabricating a memory circuit region only does not need to be performed in addition to a conventional dedicated photomask process of fabricating a memory circuit region only, thereby achieving reduction in production cost.

Brief Description of Drawings

FIG. 1 is a schematic view illustrating a planar layout of a semiconductor integrated circuit device produced by a production method of the present invention.
FIG. 2 is a cross-sectional view illustrating a cross section taken along line A-A' in FIG. 1.
FIG. 3 is a cross-sectional view illustrating a cross section taken along line B-B' in FIG. 1.

FIG. 4 is a cross-sectional view illustrating a cross section taken along line C-C' in FIG. 1.

FIG. 5A is a schematic view illustrating a production step (1) for a semiconductor integrated circuit device; FIG. 5B is a schematic view illustrating a production step (2) for a semiconductor integrated circuit device; and FIG. 5C is a schematic view illustrating a production step (3) for a semiconductor integrated circuit device.

FIG. 6A is a schematic view illustrating a production step (4) for a semiconductor integrated circuit device; FIG. 6B is a schematic view illustrating a production step (5) for a semiconductor integrated circuit device; and FIG. 6C is a schematic view illustrating a production step (6) for a semiconductor integrated circuit device.

FIG. 7A is a schematic view illustrating a production step (7) for a semiconductor integrated circuit device; FIG. 7B is a schematic view illustrating a production step (8) for a semiconductor integrated circuit device; and FIG. 7C is a schematic view illustrating a production step (9) for a semiconductor integrated circuit device.

FIG. 8 is a schematic view illustrating a production step (10) for a semiconductor integrated circuit device.

FIG. 9 is a schematic view illustrating a planar layout of a state in which a resist, which is used to form a surrounding conductive layer and a contact formation conductive layer, is disposed over the planar layout of the completed semiconductor integrated circuit device illustrated in FIG. 1.

FIG. 10A is a cross-sectional view illustrating a cross section taken along line A-A' in FIG. 9; and FIG. 10B is a cross-sectional view illustrating a cross section taken along line B-B' in FIG. 9.

FIG. 11 is a schematic view illustrating a planar layout of a surrounding conductive layer formed in a production process.

FIG. 12 is a schematic view illustrating a planar layout of a state in which a resist, which is used to form a first select gate electrode, a second select gate electrode, and logic gate electrodes, is disposed over the planar layout of the completed semiconductor integrated circuit device illustrated in FIG. 1.

FIG. 13A is a cross-sectional view illustrating a cross section taken along line A-A' in FIG. 12; and FIG. 13B is a cross-sectional view illustrating a cross section taken along line C-C' in FIG. 12.

Description of Embodiments

Hereinafter, embodiments of the present invention will be described in the following order.

1. Configuration of semiconductor integrated circuit device produced by production method of the present invention
1-1. Planar layout of semiconductor integrated circuit device
1-2. Cross-sections of sites of semiconductor integrated circuit device
1-3. Principles of operation to inject charge into charge storage layer in selected memory cell
1-4. Principles of operation not to inject charge into charge storage layer in nonselected memory cell in which high charge storage gate voltage is applied to memory gate electrode
2. Method for producing semiconductor integrated circuit device
3. Operations and effects
4. Production methods according to other embodiments without third photomask processing step
5. Other embodiments

(1) Configuration of semiconductor integrated circuit device produced by production method of the present invention

(1-1) Planar layout of semiconductor integrated circuit device

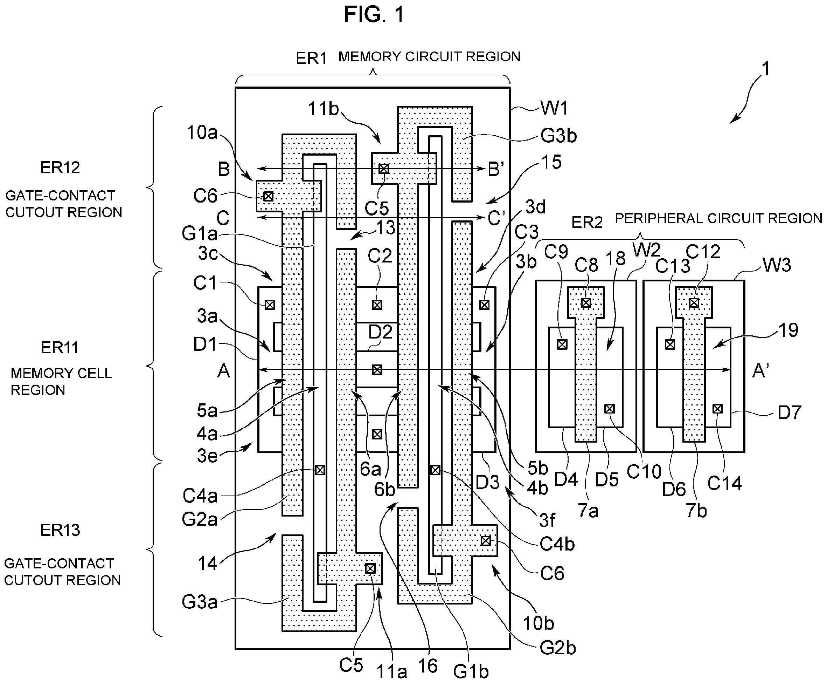

FIG. 1 is a schematic view illustrating a planar layout of a completed semiconductor integrated circuit device 1 produced by a production method of the present invention. FIG. 1 mainly illustrates a planar layout of memory gate structures 4a and 4b, first select gate structures 5a and 5b, and second select gate structures 6a and 6b, which are disposed in a memory circuit region ER1, and a planar layout of logic gate structures 7a and 7b disposed in a peripheral circuit region ER2. FIG. 1 omits illustrations of, for example, a sidewall spacer disposed on each sidewall of the memory gate structures 4a and 4b, any sidewall structure disposed on the first select gate structures 5a and 5b and the second select gate structures 6a and 6b, and any element isolation layer disposed on a memory well W1 and logic wells W1 and W2, which will be described later.

The semiconductor integrated circuit device 1 includes the memory circuit region ER1 and the peripheral circuit region ER2 on a semiconductor substrate (not illustrated). For example, the P-type memory well W1 is disposed in the memory circuit region ER1, and the P-type logic well W2 and the N-type logic well W3 are disposed in the peripheral circuit region ER2.

The memory circuit region ER1 includes a memory cell region ER11 between gate-contact cutout regions ER12 and ER13. In the memory cell region ER11, a plurality of memory cells 3a, 3b, 3c, 3d, 3e, and 3f are arranged in a matrix of rows and columns. The memory cells 3a, 3b, 3c, 3d, 3e, and 3f all have identical configurations, and thus the following description will be made mainly on the memory cells 3a and 3b disposed in a region including line A-A'.

The memory cell 3a has a configuration in which the memory gate structure 4a is disposed between the first select gate structure 5a and the second select gate structure 6a through a sidewall spacer (not illustrated). In the present embodiment, the memory gate structure 4a, which extends across the memory cells 3a, 3c, and 3e of the first column, and the memory gate structure 4b, which extends across the remaining memory cells 3b, 3d, and 3f of the second column, are formed linearly and disposed next to each other. A contact C4a (C4b) is vertically provided on the memory gate structure 4a (4b) and connected to a memory gate line (not illustrated) to allow application of a memory gate voltage from the memory gate line through the contact C4a (C4b).

In the memory cell region ER11, the first select gate structure 5a (5b) and the second select gate structure 6a (6b) are formed linearly and extend next to the memory gate structure 4a (4b) including a memory gate electrode G1a (G1b). The first select gate structure 5a (5b) includes a first select gate electrode G2a (G2b). The second select gate structure 6a (6b) includes a second select gate electrode G3a (G3b). The first select gate electrode G2a (G2b) and the second select gate electrode G3a (G3b) have sidewall-shapes and disposed along a sidewall spacer on a sidewall of the memory gate electrode G1a (G1b). The first select gate electrode G2a (G2b) and the second select gate electrode G3a (G3b) are disposed along the perimeter surrounding the memory gate electrode G1a (G1b), and electrically separated from each other by a plurality of select gate electrode cutout portions 13 and 14 (15 and 16), at which the first select gate electrode G2a (G2b) and the second select gate electrode G3a (G3b) are absent.

Two source regions D1 and D3 are symmetrically disposed at a predetermined interval therebetween on a surface (substrate surface) of the memory well W1 in the memory cell region ER11, and a plurality of drain regions D2 are disposed between the source regions D1 and D3. In the memory cell region ER11, the memory cells 3a, 3c, and 3e, in each of which the memory gate structure 4a is disposed between the first select gate structure 5a and the second select gate structure 6a, of the first column are disposed between the source region D1 and the drain region D2. The memory cells 3b, 3d, and 3f, in each of which the memory gate structure 4b is disposed between the second select gate structure 6b and the first select gate structure 5b, of the second column are disposed between the drain region D2 and the source region D3. The memory cells 3a, 3c, and 3e are symmetrical to the memory cells 3b, 3d, and 3f.

The source region D1 on the surface of the memory well W1 is disposed along the first select gate structure 5a and extends to regions adjacent to the first select gate structure 5a, in accordance with the positions of the memory cells 3a, 3c, and 3e of the first column. The source region D1 is shared by the memory cells 3a, 3c, and 3e arranged in one column. A contact C1 is connected to a source line (not illustrated) and vertically provided on the source region D1, to allow application of a source voltage from the source line through the contact C1.

The drain regions D2 on the surface of the memory well W1 between the second select gate structures 6a and 6b are disposed in regions adjacent to the second select gate structures 6a and 6b, in accordance with the positions of the adjacent memory cells 3a and 3b (3c and 3d, and 3e and 3f). One drain region D2 is shared by the adjacent memory cells 3a and 3b (3c and 3d, or 3e and 3f). A contact C2 is connected to a bit line (not illustrated) and vertically provided on the drain region D2, to allow application of a bit voltage through the contact C2 from the bit line. In FIG. 1, the bit line (not illustrated) is shared by the memory cells 3a and 3b (3c and 3d, or 3e and 3f) arranged in a row direction, to allow application of an identical bit voltage to the memory cells 3a and 3b (3c and 3d, or 3e and 3f) on a row-by-row basis.

The source region D3 on the surface of the memory well W1 is symmetrical to the source region D1. Similar to the source region D1, the source region D3 extends to regions adjacent to the first select gate structure 5b. The source region D3 is shared by the memory cells 3b, 3d, and 3f of the second column. A contact C3 is vertically provided on the source region D3 and connected to the same source line for the source region D1. Accordingly, an identical source voltage is applied through the contacts C1 and C3 to the memory cells 3a, 3b, 3c, 3d, 3e, and 3f disposed in the memory cell region ER11.

The two memory gate electrodes G1a and G1b, which are disposed next to each other in the memory cell region ER11, extend linearly and next to each other in the gate-contact cutout region ER12 and the gate-contact cutout region ER13 adjacent to the memory cell region ER11. The memory gate electrodes G1a and G1b each have one end disposed in the gate-contact cutout region ER12 and the other end disposed in the gate-contact cutout region ER13.

In the present embodiment, the first select gate electrode G2a, the memory gate electrode G1a, and the second select gate electrode G3a included in the memory cells 3a, 3c, and 3e of the first column are symmetrical to the second select gate electrode G3b, the memory gate electrode G1b, and the first select gate electrode G2b included in the memory cells 3b, 3d, and 3f of the second column. Thus, the following description of the gate-contact cutout regions ER12 and ER13 will be made with regard to the first select gate electrode G2a, the memory gate electrode G1a, and the second select gate electrode G3a included in the memory cells 3a, 3c, and 3e of the first column.

The gate-contact cutout region ER12 includes a contact formation conductive layer 10a disposed at a predetermined position on the first select gate electrode G2a extending from the memory cell region ER11, and also includes the select gate electrode cutout portion 13 separating the first select gate electrode G2a and the second select gate electrode G3a from each other.

In the present embodiment, the contact formation conductive layer 10a is disposed at a predetermined position on the first select gate electrode G2a in the gate-contact cutout region ER12. In the gate-contact cutout region ER12, the first select gate electrode G2a extends from the contact formation conductive layer 10a in a distal direction from the memory cell region ER11, and then bends around one end of the memory gate electrode G1a so that an end of the first select gate electrode G2a is disposed on a side where the corresponding second select gate electrode G3a is disposed.

The gate-contact cutout region ER12 includes an end of the second select gate electrode G3a extending from the memory cell region ER11. The end of the first select gate electrode G2a and the end of the second select gate electrode G3a face each other at a predetermined distance and are disposed along one straight line, to form the select gate electrode cutout portion 13, through which the first select gate electrode G2a and the second select gate electrode G3a are separated from each other.

A contact C6 connected to a first select gate line (not illustrated) is vertically provided on the contact formation conductive layer 10a. Upon receiving a first select gate voltage from the first select gate line through the contact C6, the contact formation conductive layer 10a allows application of the first select gate voltage only to the first select gate electrode G2a.

The gate-contact cutout region ER13 includes a contact formation conductive layer 11a disposed at a predetermined position on the second select gate electrode G3a extending from the memory cell region ER11, and also includes the select gate electrode cutout portion 14 separating the first select gate electrode G2a from the second select gate electrode G3a.

In the present embodiment, in the gate-contact cutout region ER13, the second select gate electrode G3a extends from the contact formation conductive layer 11a in a distal direction from the memory cell region ER11, and then bends around the other end of the memory gate electrode G1a so that an end of the second select gate electrode G3a is disposed on a side where the corresponding first select gate electrode G2a is disposed.

The gate-contact cutout region ER13 includes an end of the first select gate electrode G2a extending from the memory cell region ER11. The end of the first select gate electrode G2a and the end of the second select gate electrode G3a face each other at a predetermined distance and are disposed along one straight line, to form the select gate electrode cutout portion 14, which separates the first select gate electrode G2a from the second select gate electrode G3a.

A contact C5 connected to a second select gate line (not illustrated) is vertically provided on the contact formation conductive layer 11a. Upon receiving a second select gate voltage from the second select gate line through the contact C5, the contact formation conductive layer 11a allows application of the second select gate voltage only to the second select gate electrode G3a.

Accordingly, in the memory circuit region ER1, the first select gate electrode G2a, which is continuous with the contact formation conductive layer 10a, is electrically separated from the second select gate electrode G3a, which is continuous with the contact formation conductive layer 11a, by the select gate electrode cutout portions 13 and 14. This electrical separation allows separate control of the first select gate electrode G2a and the second select gate electrode G3a.

In the gate-contact cutout regions ER12 and ER13, the second select gate electrode G3b, the memory gate electrode G1b, and the first select gate electrode G2b on the second column have the same configurations as those of the first select gate electrode G2a, the memory gate electrode G1a, and the second select gate electrode G3a, respectively, on the first column described above, except that, in the gate-contact cutout region ER12, a contact formation conductive layer 11b is disposed at a predetermined position on the second select gate electrode G3b, and the select gate electrode cutout portion 15, through which the first select gate electrode G2b and the second select gate electrode G3b are separated from each other, is provided on a side where the first select gate electrode G2b is disposed.

In addition, the gate-contact cutout region ER13 is different in that a contact formation conductive layer 10b is disposed at a predetermined position on the first select gate electrode G2b, and the select gate electrode cutout portion 16, through which the first select gate electrode G2b and the second select gate electrode G3b are separated from each other, is provided on a side where the second select gate electrode G3b is disposed.

Thus, in the configuration including the second select gate electrode G3b, the memory gate electrode G1b, and the first select gate electrode G2b, the first select gate electrode G2b is electrically separated from the second select gate electrode G3b by the select gate electrode cutout portions 15 and 16 provided between the first select gate electrode G2b, which is continuous with the contact formation conductive layer 10b, and the second select gate electrode G3b, which is continuous with the contact formation conductive layer 11b. This electrical separation allows separate control of the first select gate electrode G2b and the second select gate electrode G3b.

The following describes the peripheral circuit region ER2 adjacent to the memory circuit region ER1 with the above-described configuration. In the present embodiment, the peripheral circuit region ER2 is disposed at a position adjacent to the memory cell region ER11 of the memory circuit region ER1, but the present invention is not limited this configuration. The peripheral circuit region ER2 may be disposed at various positions such as a position adjacent to the gate-contact cutout region ER12, a position adjacent to the gate-contact cutout region ER13, or a position adjacent to a region between the memory cell region ER11 and the gate-contact cutout region ER12.

A plurality of peripheral circuits 18 and 19 are disposed in the peripheral circuit region ER2. The peripheral circuit 18 includes, for example, an N-type metal-oxide-semiconductor (MOS) transistor structure on the P-type logic well W2. In such a case, the logic well W2 includes a logic gate structure 7a to allow application of a logic gate voltage to the logic gate structure 7a through a contact C8.

On the logic well W2, impurity diffusion regions D4 and D5 are disposed in regions adjacent to the logic gate structure 7a such that the logic gate structure 7a is disposed between the impurity diffusion regions D4 and D5. A contact C9 is vertically provided on the impurity diffusion region D4. A contact C10 is vertically provided on the impurity diffusion region D5.

The peripheral circuit 19 includes, for example, a P-type MOS transistor structure on the N-type logic well W3. In such a case, the logic well W3 includes a logic gate structure 7b to allow application of a logic gate voltage to the logic gate structure 7b through a contact C12.

On the logic well W3, impurity diffusion regions D6 and D7 are disposed in regions adjacent to the logic gate structure 7B such that the logic gate structure 7b is disposed between the impurity diffusion regions D6 and D7. A contact C13 is vertically provided on the impurity diffusion region D6. A contact C14 is vertically provided on the impurity diffusion region D7.

(1-2) Cross-sections of sites of semiconductor integrated circuit device

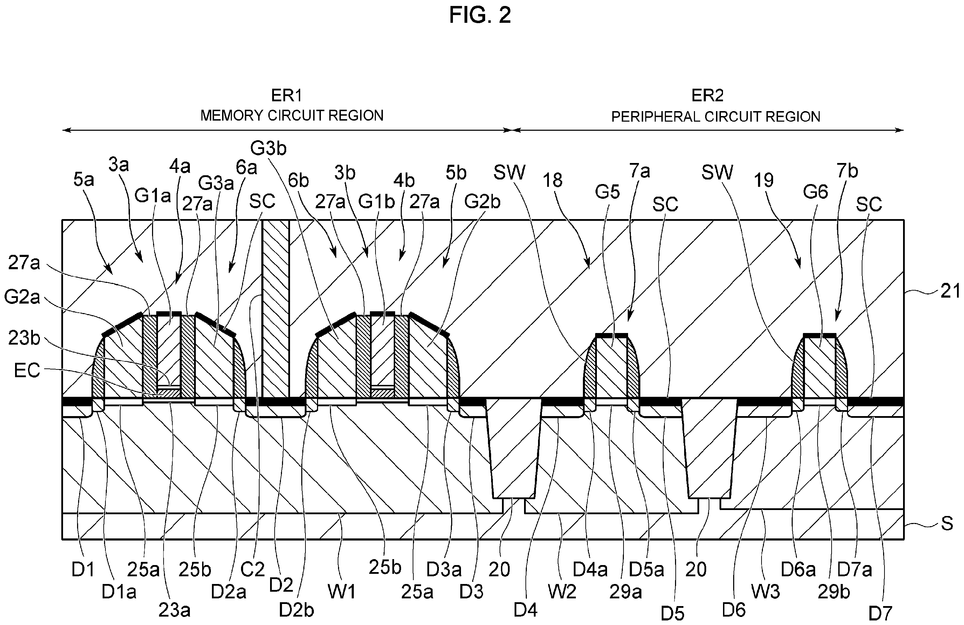

FIG. 2 is a cross-sectional view illustrating cross sections of the memory cells 3a and 3b in the memory cell region ER11 and the peripheral circuits 18 and 19 in the peripheral circuit region ER2, taken along line A-A' in FIG. 1. The semiconductor integrated circuit device 1 includes the semiconductor substrate S. The memory well W1 is disposed on the semiconductor substrate S in the memory circuit region ER1, and the logic wells W2 and W3 are disposed on the semiconductor substrate S in the peripheral circuit region ER2.

In the present embodiment, on the memory well W1, the two memory cells 3a and 3b are disposed in a region including line A-A', and the drain region D2, on which the contact C2 is vertically provided, is disposed on the surface between the memory cells 3a and 3b. Since the memory cells 3a and 3b are symmetrically disposed but have identical configurations, the memory cell 3a will be described below.

On the memory well W1, the memory cell 3a includes, for example, the memory gate structure 4a having an N-type transistor structure, the first select gate structure 5a having an N-type MOS transistor structure, and the second select gate structure 6a having an N-type MOS transistor structure.

The source region D1 and each drain region D2 are spaced at a predetermined distance on the surface of the memory well W1. A source voltage from a source line is applied to the source region D1 through the contact C1 (FIG. 1), and a bit voltage from a bit line is applied to the drain region D2 through the contact C2. In the present embodiment, impurity concentration is $1.0E21/cm^3$ or more in each of the source region D1 and the drain region D2. In the memory well W1, the impurity concentration of a surface region (for example, a region extending to the depth of 50 nm from the surface) in which a channel layer is formed is $1.0E19/cm^3$ or less, preferably is $3.0E18/cm^3$ or less, which is set by impurity implantation performed in a production process.

The memory gate structure 4a includes a charge storage layer EC containing, for example, silicon nitride ($Si_3N_4$), silicon oxynitride (SiON), or alumina ($Al_2O_3$) on the memory well W1 between the source region D1 and the drain region D2 through a lower gate insulating film 23a made of an insulating member such as $SiO_2$. The memory gate structure 4a further includes the memory gate electrode G1a on the charge storage layer EC through an upper gate insulating film 23b made of an insulating member such as $SiO_2$. The lower gate insulating film 23a and the upper gate insulating film 23b of the memory gate structure 4a insulate the charge storage layer EC from the memory well W1 and the memory gate electrode G1a.

The sidewall spacer 27a made of the insulating member is disposed along the sidewall of the memory gate structure 4a. The memory gate structure 4a is adjacent to the first select gate structure 5a through the sidewall spacer 27a. This sidewall spacer 27a, which is disposed between the memory gate structure 4a and the first select gate structure 5a, has the thickness enough to insulate the memory gate structure 4a from the first select gate structure 5a.

The first select gate structure 5a includes a gate insulating film 25a made of an insulating member on the memory well W1 between the sidewall spacer 27a and the source region D1. The gate insulating film 25a has the thickness of less than or equal to 9 nm, preferably less than or equal to 3 nm. The first select gate electrode G2a, to which the first select gate line is connected, is disposed on the gate insulating film 25a.

The sidewall spacer 27a made of the insulating member is disposed along the sidewall of the memory gate structure 4a. The memory gate structure 4a is adjacent to the second select gate structure 6a through the sidewall spacer 27a. This sidewall spacer 27a, which is disposed between the memory gate structure 4a and the second select gate structure 6a, has the same thickness as that of the sidewall spacer 27a between the memory gate structure 4a and the first select gate structure 5a, and insulates the memory gate structure 4a from the second select gate structure 6a.

The second select gate structure 6a includes a gate insulating film 25b made of an insulating member on the memory well W1 between the sidewall spacer 27a and the drain region D2. The gate insulating film 25b has the thickness of less than or equal to 9 nm, preferably less than or equal to 3 nm. The second select gate electrode G3a, to which the second select gate line is connected, is disposed on the gate insulating film 25b.

The first select gate electrode G2a and the second select gate electrode G3a, which are disposed along the sidewall of the memory gate electrode G1a through the sidewall spacer 27a, are formed by etching back through a production process to be described later. The first select gate electrode G2a and the second select gate electrode G3a each have a sidewall shape in which the height of the first select gate electrode G2a or the second select gate electrode G3a decreases with the distance from the memory gate electrode G1a such that the top portion of the first select gate electrode G2a or the second select gate electrode G3a is sloped (angled) toward the memory well W1.

A sidewall structure SW made of an insulating member is disposed on the sidewall of the first select gate structure 5a and on the sidewall of the second select gate structure 6a. An extension region D1a is disposed in a region of a surface of the memory well W1 below one of the sidewall structures SW, and an extension region D2a is disposed in a region of the surface of the memory well W1 below the other sidewall structure SW.

In the present embodiment, when impurity concentration is $1E19/cm^3$ or less in a region extending to the depth of 50 nm from the surface of the memory well W1 between the first select gate electrode G2a and the second select gate electrode G3a, the gate insulating films 25a and 25b are each formed to have the thickness of less than or equal to 9 nm through a subsequent production step. When impurity concentration is $3E18/cm^3$ or less in a region extending to the depth of 50 nm from the surface of the memory well W1 between the first select gate electrode G2a and the second select gate electrode G3a, the gate insulating films 25a and 25b are each formed to have the thickness of less than or equal to 3 nm through a subsequent production step.

The memory cell 3b has a configuration similar to the memory cell 3a. The memory cell 3b includes the memory gate structure 4b on the memory well W1 between the source region D3 and the drain region D2. The memory gate structure 4b is disposed on the memory well W1 between the first select gate structure 5b and the second select gate structure 6b through the sidewall spacer 27a. In the memory cell 3b, an extension region D3a is disposed in a region of the surface of the memory well W1 below the sidewall structure SW formed on the sidewall of the first select gate structure 5b, whereas an extension region D2b is disposed in a region of the surface of the memory well W1 below the sidewall structure SW formed on the sidewall of the second select gate structure 6b.

The memory well W1 disposed in the memory circuit region ER1 is electrically insulated from the logic well W2 disposed in the peripheral circuit region ER2 by an element isolation layer 20. The logic well W2 disposed in the peripheral circuit region ER2 is electrically insulated from the logic well W3 by another element isolation layer 20. In the present embodiment, the peripheral circuit 18 having an N-type MOS transistor structure is disposed on the logic well W2, whereas the peripheral circuit 19 having a P-type MOS transistor structure is disposed on the logic well W3.

The logic gate structure 7a on the logic well W2 includes a logic gate electrode G5 disposed, through a gate insulating film 29a, between a pair of the impurity diffusion regions D4 and D5 disposed on the surface. The sidewall structure SW is disposed on a sidewall of the logic gate structure 7a. Extension regions D4a and D5a are respectively disposed in regions of the logic well W2 surface below the sidewall structures SW.

The logic well W3, which has a conductivity type different from that of the logic well W2, has a configuration similar to that of the logic well W2. The logic gate structure 7b on the logic well W3 includes a logic gate electrode G6 disposed, through a gate insulating film 29b, between a pair of the impurity diffusion regions D6 and D7 in the surface. The sidewall structure SW is disposed on a sidewall of the logic gate structure 7b. Extension regions D6a and D7a are respectively disposed in regions of the logic well W2 surface below the sidewall structures SW.

An insulating layer 21 covers sites such as the first select gate structures 5a and 5b, the memory gate structures 4a and 4b, the second select gate structures 6a and 6b, the contact C2, and the logic gate structures 7a and 7b of the semiconductor integrated circuit device 1 so as to insulate these sites from each other. Silicide SC covers surfaces of other various sites such as the source regions D1 and D3 and the drain regions D2.

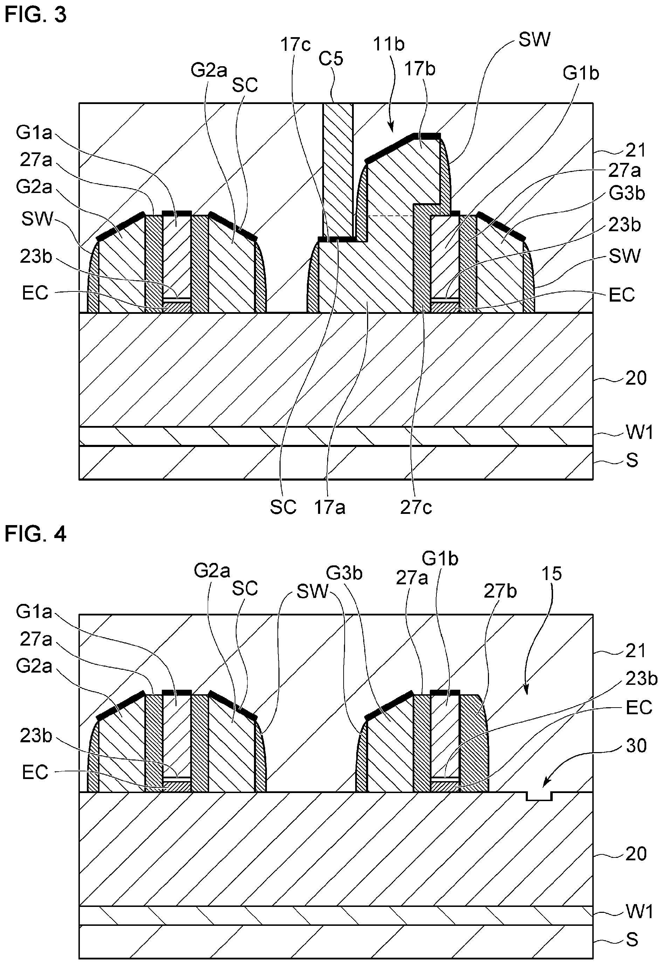

FIG. 3 is a cross-sectional view taken along line B-B' in FIG. 1, illustrating a cross section of the contact formation conductive layer 11b provided to the second select gate electrode G3b in the gate-contact cutout region ER12 of the memory circuit region ER1. As illustrated in FIG. 3, the contact formation conductive layer 11b is disposed on the element isolation layer 20 on the memory well W1.

The contact formation conductive layer 11b mounts across (extends over) one sidewall of the memory gate electrode G1b and part of a top portion of the memory gate electrode G1b from a surface (substrate surface) of the element isolation layer 20. A contact installation surface 17c is disposed on a base 17a disposed on the element isolation layer 20. The contact installation surface 17c has a flat shape in accordance with the surface shape of the element isolation layer 20. A sidewall spacer 27c is disposed between the contact formation conductive layer 11b and the memory gate electrode G1b to insulate the contact formation conductive layer 11b from the memory gate electrode G1b.

The column-shaped contact C5 is vertically provided on the contact installation surface 17c of the contact formation conductive layer 11b through the silicide SC. The second select gate voltage is applied through the contact C5. Accordingly, the second select gate voltage is applied to the second select gate electrode G2b through the contact formation conductive layer 11b. In the contact formation conductive layer 11b, the sidewall structure SW is disposed on each of a sidewall of the base 17a and a sidewall of a mounting portion 17b. The mounting portion 17b is integral with the base 17a and extends to the top portion of the memory gate electrode G1b.

In the present embodiment, as illustrated in FIG. 1, the second select gate electrode G3b, on which the contact formation conductive layer 11b is disposed, bends around one end of the memory gate electrode G1b so that an end of the second select gate electrode G3b faces the contact formation conductive layer 11b through the memory gate electrode G1b. Thus, in FIG. 3, which illustrates a cross section taken along line B-B' in FIG. 1, the contact formation conductive layer 11b faces the second select gate electrode G3b provided continuously with the contact formation conductive layer 11b and bending around one end of the memory gate electrode G1b, through the memory gate electrode G1b and the sidewall spacers 27a and 27c.

As illustrated in FIG. 3 taken along line B-B' in FIG. 1, since the first select gate electrode G2a bends around one end of the memory gate electrode G1a on a side where the memory gate electrode G1a is disposed (FIG. 1), the first select gate electrode G2a faces the first select gate electrode G2a through the memory gate electrode G1a and the sidewall spacer 27a.

FIG. 4 is a cross-sectional view, which is taken along line C-C' in FIG. 1, illustrating a cross section of the select gate electrode cutout portion 15 in the gate-contact cutout region ER12 of the memory circuit region ER1. As illustrated in FIG. 4, in a region (region on the right side in FIG. 4) in which the select gate electrode cutout portion 15 is disposed, the second select gate electrode G3b is formed on the one sidewall of the memory gate electrode G1b through the sidewall spacer 27a. In this region, however, the first select gate electrode G2b and the second select gate electrode G3b are not disposed on the other sidewall of the memory gate electrode G1b, but only an insulation wall 27b including a sidewall spacer or a sidewall structure.

In the region in which the select gate electrode cutout portion 15 is disposed, a recess 30 is formed on a surface (substrate surface) of the element isolation layer 20 by removing a part of the substrate surface in a production process. In the present embodiment, on the side where the memory gate electrode G1a is disposed in the drawing taken along line C-C' in FIG. 1, the first select gate electrode G2a faces the first select gate electrode G2a through the memory gate electrode G1a and the sidewall spacer 27a.

(1-3) Principles of operation to inject charge into charge storage layer in selected memory cell

The following gives simple description of a case in which data is programmed to the memory cell 3a by injecting charge into, for example, the charge storage layer EC of the memory cell 3a in the semiconductor integrated circuit device 1 produced by the production method of the present invention. In this case, as illustrated in FIG. 2, in the memory cell (may be referred to as a selected memory cell) 3a in which charge is injected into the charge storage layer EC, the charge storage gate voltage of 12 V is applied from the memory gate line (not illustrated) to the memory gate electrode G1a of the memory gate structure 4a through the contact C4a (FIG. 1) so as to form the channel layer (not illustrated) along the surface of the memory well W1 facing the memory gate electrode G1a.

In this case, the gate OFF voltage of 0 V is applied to the first select gate electrode G2a of the first select gate structure 5a from the first select gate line (not illustrated) through the contact C6 (FIG. 1) and the contact formation conductive layer 10a, and the source OFF voltage of 0 V is applied to the source region D1. Accordingly, no channel layer is formed in the surface region of the memory well W1 facing the first select gate electrode G2a. The first select gate structure 5a blocks the electrical connection between the source region D1 and the channel layer below the memory gate structure 4a, and prevents voltage application from the source region D1 to the channel layer below the memory gate structure 4a.

The second select gate voltage of 1.5 V is applied to the second select gate electrode G3a of the second select gate structure 6a from the second select gate line (not illustrated) through the contact C5 (FIG. 1) and the contact formation conductive layer 11a. The charge storage bit voltage of 0 V is applied to the drain regions D2. Accordingly, a channel layer is formed in the memory well W1 facing the second select gate electrode G3a of the second select gate structure 6a, and the memory well W1 becomes a conductive state. Hence, the drain region D2 is electrically connected to the channel layer below the memory gate structure 4a, and the charge storage bit voltage of 0 V is applied to the channel layer below the memory gate structure 4a. In this case, the substrate voltage of 0 V, which is the same as the charge storage bit voltage, is applied to the memory well W1.

Accordingly, since the memory gate electrode G1a has a voltage of 12 V and the channel layer below the memory gate structure 4a has a voltage of 0 V, a large voltage difference of 12 V occurs between the memory gate electrode G1a and the channel layer. This voltage difference causes the quantum tunneling effect, by which charge is injected into the charge storage layer EC to program data.

(1-4) Principles of operation not to inject charge into charge storage layer in nonselected memory cell in which high charge storage gate voltage is applied to memory gate electrode

In the semiconductor integrated circuit device 1 produced by the production method of the present invention, for example, when no charge is to be injected into the charge storage layer EC of the memory cell 3a, a high charge storage gate voltage the same as that for data programming is applied to the memory gate electrode G1a. With this voltage application, the first select gate structure 5a blocks the electrical connection between the source region D1 and the channel layer below the memory gate structure 4a, and the second select gate structure 6a blocks the electrical connection between the drain region D2 and the channel layer below the memory gate structure 4a. Accordingly, charge is prevented from being injected into the charge storage layer EC of the memory gate structure 4a.

In this case, the charge storage gate voltage of 12 V is applied to the memory gate electrode G1a of the memory gate structure 4a in the memory cell (may be referred to as a nonselected memory cell) 3a in which no charge is to be injected into the charge storage layer EC. The charge storage gate voltage is applied (transmitted) to the memory well W1, thereby forming a channel layer along the surface of the memory well W1 facing the memory gate electrode G1a.

The gate OFF voltage of 0 V is applied to the first select gate electrode G2a of the first select gate structure 5a from the first select gate line (not illustrated) through the contact C6 (FIG. 1) and the contact formation conductive layer 10a. The source OFF voltage of 0 V is applied to the source region D1. Accordingly, the memory well W1 facing the first select gate electrode G2a of the memory cell 3a is in a non-conductive state, and thus the first select gate structure 5a blocks the electrical connection between the source region D1 and the channel layer below the memory gate structure 4a.

In addition, the second select gate voltage of 1.5 V is applied to the second select gate electrode G3a of the second select gate structure 6a from the second select gate line (not illustrated) through the contact C5 (FIG. 1) and the contact formation conductive layer 11a. The off voltage of 1.5 V is applied to the drain region D2. Accordingly, the memory well W1 facing the second select gate electrode G3a is in a non-conductive state, and thus the second select gate structure 6a blocks the electrical connection between the drain region D2 and the channel layer below the memory gate structure 4a.

As described above, a region of the memory well W1 below the first select gate structure 5a and a region of the memory well W1 below the second select gate structure 6a become non-conductive states. The first and second select gate structures 5a and 6a are disposed on the respective sides of the memory gate structure 4a of the memory cell 3a. The non-conductive states block the electrical connection between the source region D1 and the channel layer, which faces the memory gate electrode G1a and is formed in the surface region of the memory well W1, and the electrical connection between the drain region D2 and the channel layer. Accordingly, a depletion layer is formed around the channel layer.

A capacitor (hereinafter referred to as a gate-insulator capacitor) C2 is achieved by a three-layer configuration of the upper gate insulating film 23b, the charge storage layer EC, and the lower gate insulating film 23a. A capacitor (hereinafter referred to as a depletion-layer capacitor) C1 of the depletion layer is formed in the memory well W1 and surrounds the channel layer. The capacitors C1 and C2 are connected to each other in series. For example, when the gate-insulator capacitor C2 has a capacitance three times as large as that of the depletion-layer capacitor C1, the channel layer has a channel potential Vch calculated to be 9 V by a formula below.

[Formula 1]

$$Vch = (\text{Memory gate voltage MV} - \text{Substrate voltage CV}) \times \frac{\text{Capacitance of gate-insulator capacitor C2}}{\text{Capacitance of depletion-layer capacitor C1} + \text{Capacitance of gate-insulator capacitor C2}}$$

Thus, in the memory gate structure 4a, the channel potential Vch of the channel layer surrounded by the depletion layer in the memory well W1 is 9 V when the charge storage gate voltage of 12 V is applied to the memory gate electrode G1a. Accordingly, there is a small voltage difference of 3 V between the memory gate electrode G1a and the channel layer. As a result, the quantum tunneling effect does not occur, and thus charge is prevented from being injected into the charge storage layer EC.

In the memory cell 3a, an impurity diffusion region having a high impurity concentration is not formed in a region of the memory well W1 between the memory gate structure 4a and the first select gate structure 5a nor a region of the memory well W1 between the memory gate structure 4a and the second select gate structure 6a. Thus, the depletion layer is reliably formed around the channel layer formed near the surface of the memory well W1. The depletion layer prevents application of the channel potential Vch from the channel layer to the gate insulating films 25a and 25b of the respective first select gate structure 5a and the second select gate structure 6a.

Accordingly, in the memory cell 3a, the depletion layer prevents the channel potential Vch of the channel layer from being applied to the gate insulating films 25a and 25b when the gate insulating films 25a and 25b of the first select gate structure 5a and the second select gate structure 6a have thicknesses reduced in accordance with a low source voltage applied to the source region D1 and a low bit voltage applied to the drain region D2. Thus, the insulation breakdown of the gate insulating films 25a and 25b due to the channel potential Vch is avoided.


(2) Method for producing semiconductor integrated circuit device

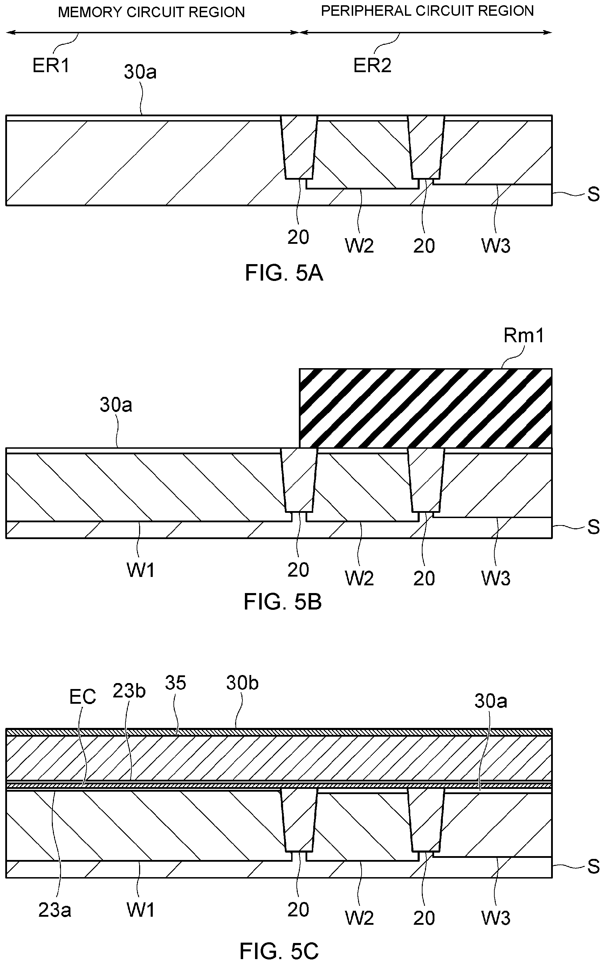

The semiconductor integrated circuit device 1 having the above-described configuration is produced through a production process described below, without an extra dedicated photomask process of fabricating only a memory circuit region ER1, in addition to a conventional dedicated photomask process of fabricating only a memory circuit region ER1. FIGS. 5A, 5B, and 5C each illustrate a cross section taken along line A-A' in FIG. 1. In this step, first, as illustrated in FIG. 5A, after the semiconductor substrate S is prepared, the element isolation layer 20 made of an insulating member is formed at predetermined positions such as boundaries of the memory circuit region ER1 and the peripheral circuit region ER2 by, for example, a shallow trench isolation (STI) method.

Subsequently, a sacrificial oxide film 30a is formed on a surface of the semiconductor substrate S by, for example, a thermal oxidation method to perform impurity implantation. Then, the P-type logic well W2 and the N-type logic well W3 are formed by implanting P-type impurities and N-type impurities, respectively, into the peripheral circuit region ER2 by, for example, an ion implantation technique.

Subsequently, a resist is patterned by a photolithography technique and an etching technique using a first photomask (not illustrated) dedicated to fabrication of the memory circuit region ER1. As illustrated in FIG. 5B, in which any corresponding part to that in FIG. 5A is denoted by an identical reference numeral, the memory circuit region ER1 is exposed, and a resist Rm1 covering the peripheral circuit region ER2 is formed.

Subsequently, the memory well W1 is formed by implanting P-type impurities only into the memory circuit region ER1 by using the patterned resist Rm1. In addition, N-type impurities are implanted into the memory circuit region ER1 to form a channel formation layer (not illustrated) on the substrate surface facing the memory gate electrodes G1a and G1b and the sidewall spacer 27a (FIG. 2), which are to be formed later. Then, the resist Rm1 is used to remove the sacrificial oxide film 30a in the memory circuit region ER1 by using, for example, hydrofluoric acid (first photomask processing step).

In the first photomask processing step, in a case in which a P-type substrate is used as the semiconductor substrate S, the step of forming the memory well W1 by implanting P-type impurities into the semiconductor substrate S may be omitted.

Subsequently, after the resist Rm1 is removed, as illustrated in FIG. 5C, in which any corresponding part to that in FIG. 5B is denoted by an identical reference numeral, an ONO film, in which the layer-shaped (sheet-shaped) lower gate insulating film 23a, the layer-shaped charge storage layer EC, and the layer-shaped upper gate insulating film 23b are stacked in this order, is formed on the entire surfaces of the memory circuit region ER1 and the peripheral circuit region ER2. Then, a memory gate electrode conductive layer 35, which is to be formed into the memory gate electrodes G1a and G1b, is formed on the upper gate insulating film 23b. Subsequently, a protection insulating layer 30b made of an insulating member is formed on the memory gate electrode conductive layer 35 by, for example, the thermal oxidation method or a chemical vapor deposition (CVD) method.

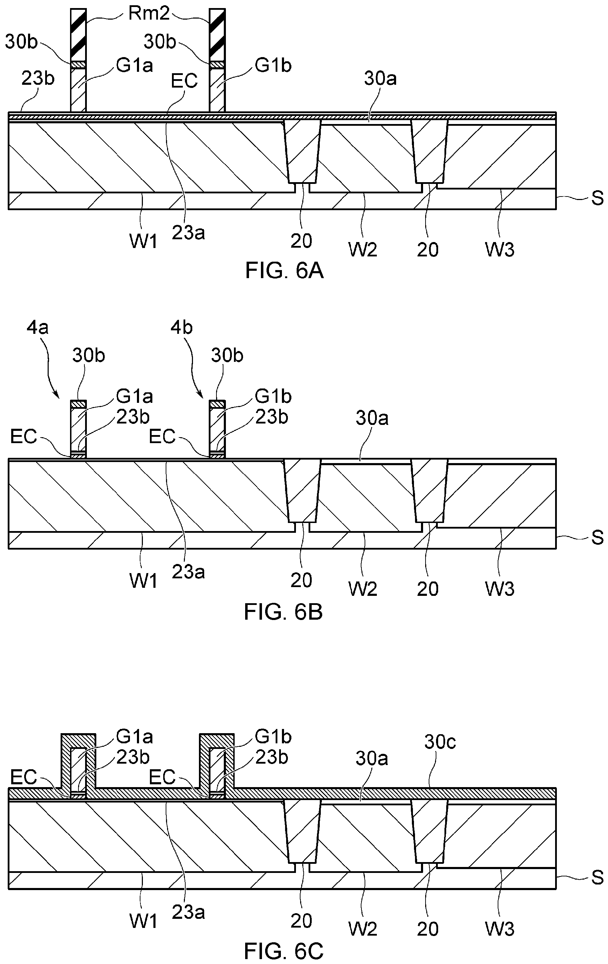

Subsequently, a resist is patterned by the photolithography technique and the etching technique using a second photomask (not illustrated) dedicated to fabrication of the memory circuit region ER1. As illustrated in FIG. 6A, in which any corresponding part to that in FIG. 5C is denoted by an identical reference numeral, a resist Rm2 is formed only where the memory gate structures 4a and 4b are to be formed. Then, the memory gate electrode conductive layer 35 is patterned by using the resist Rm2, and thus, the memory gate electrodes G1a and G1b are formed (second photomask processing step).

Subsequently, after the resist Rm2 is removed, the upper gate insulating film 23b and the charge storage layer EC exposed in regions other than the memory gate electrodes G1a and G1b to be formed are removed (ON film is removed) in this order as illustrated in FIG. 6B, in which any corresponding part to that in FIG. 6A is denoted by an identical reference numeral. Accordingly, the upper gate insulating film 23b and the charge storage layer EC are patterned below the patterned memory gate electrodes G1a and G1b. As a result, the lower gate insulating film 23a, the charge storage layer EC, the upper gate insulating film 23b, and the memory gate electrode G1a (G1b) are stacked in this order to form the memory gate structure 4a (4b) in the memory circuit region ER1 (memory gate structure formation step).

Subsequently, a protection insulating film 30c is formed on the entire surfaces of the memory circuit region ER1 and the peripheral circuit region ER2 as illustrated in FIG. 6C, in which any corresponding part to that in FIG. 6B is denoted by an identical reference numeral. The present embodiment describes a case in which the single-layer protection insulating film 30c is formed on the entire surfaces, but the present invention is not limited to a single-layer film. For example, a two-layer protection insulating film in which an oxide-based insulating film and a nitride-based insulating film are stacked in this order may be formed on the entire surfaces.

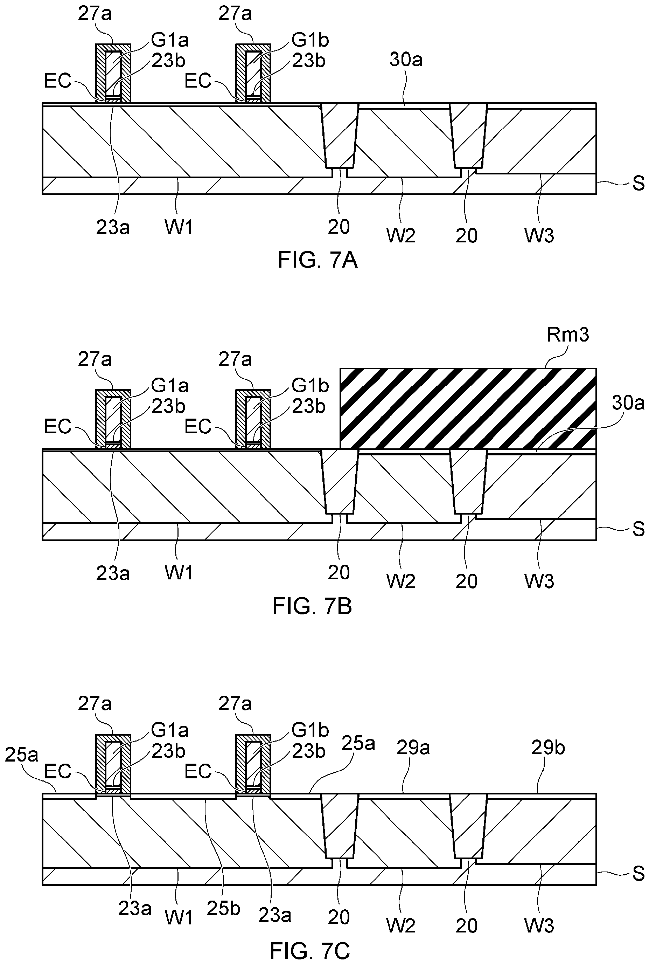

Subsequently, as illustrated in FIG. 7A, in which any corresponding part to that in FIG. 6C is denoted by an identical reference numeral, the protection insulating film 30c is etched back to form the sidewall spacers 27a covering the memory gate structures 4a and 4b (sidewall spacer formation step). Subsequently, a resist is patterned by the photolithography technique and the etching technique using a third photomask (not illustrated) dedicated to fabrication of the memory circuit region ER1. This patterning forms a resist Rm3 covering the entire surface of the peripheral circuit region ER2 but leaving the memory circuit region ER1 exposed, as illustrated in FIG. 7B, in which any corresponding part to that in FIG. 7A is denoted by an identical reference numeral.

Subsequently, impurities are implanted by using the resist Rm3 into portions of the memory circuit region ER1 where the first select gate structures 5a and 5b (FIG. 2) and the second select gate structures 6a and 6b (FIG. 2) are to be formed. This impurity implantation forms a channel formation layer (not illustrated) in regions of the substrate surface facing the second select gate electrodes G3a and G3b and the first select gate electrode G2a and G2b, which are to be formed later (third photomask processing step).

Subsequently, after the resist Rm3 is removed, the sacrificial oxide film 30a in the peripheral circuit region ER2 is removed by using, for example, hydrofluoric acid. Then, as illustrated in FIG. 7C, in which any corresponding part to that in FIG. 7B is denoted by an identical reference numeral, for example, the thermal oxidation method is employed to form the gate insulating films 25a and 25b on the portions of the memory circuit region ER1 where the first select gate electrode G2a and G2b (FIG. 1) and the second select gate electrodes G3a and G3b are to be formed. The thermal oxidation method is also employed to form the gate insulating films 29a and 29b on the portions of the peripheral circuit region ER2 where the logic gate electrodes G5 and G6 (FIG. 1) are to be formed.

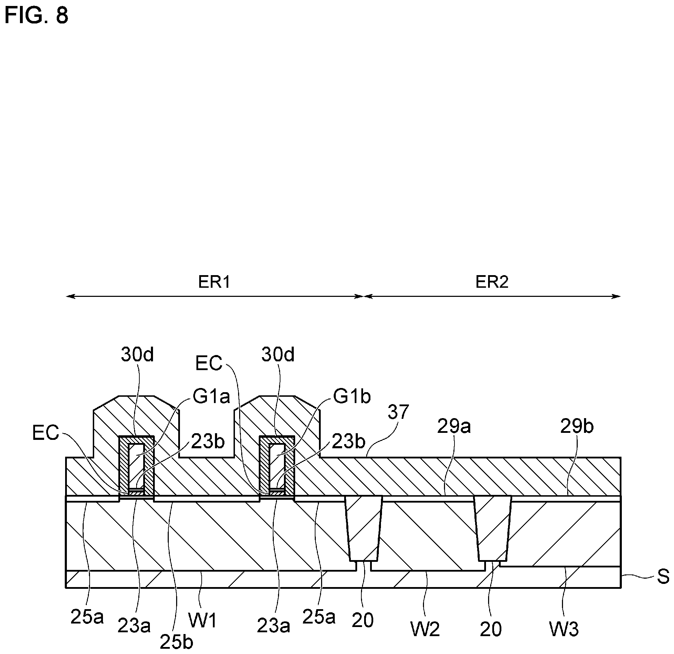

Subsequently, as illustrated in FIG. 8, in which any corresponding part to that in FIG. 7C is denoted by an identical reference numeral, a conductive layer 37, which is formed into the first select gate electrodes G2a and G2b, the second select gate electrodes G3a and G3b, and the logic gate electrodes G5 and G6 through later processing, is formed on the entire surfaces of the memory circuit region ER1 and the peripheral circuit region ER2.

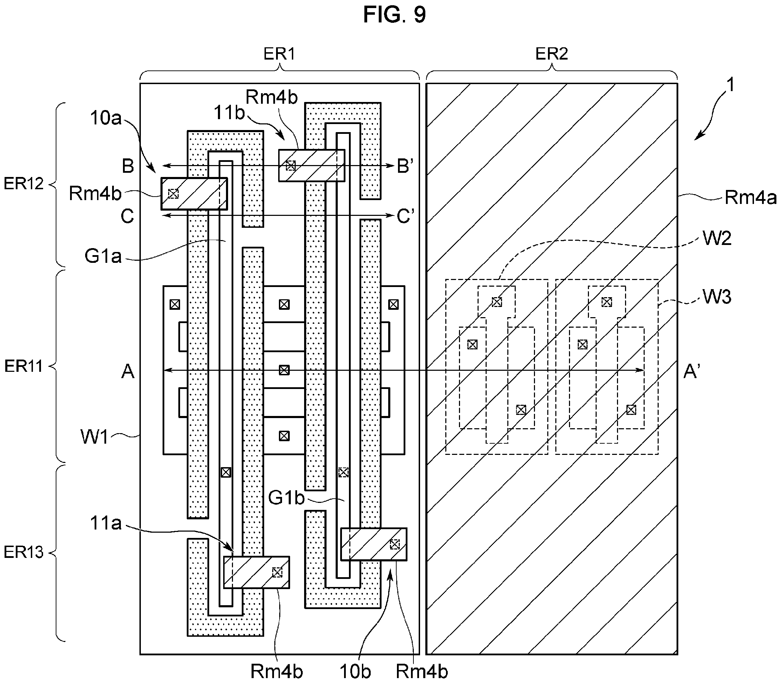

Subsequently, a resist is patterned by the photolithography technique and the etching technique by using a fourth photomask (not illustrated) dedicated to fabrication of the memory circuit region ER1. Only the conductive layer 37 in the memory circuit region ER1 is processed by using the resist. FIG. 9 is a schematic view illustrating a state in which resists Rm4a and Rm4b patterned by using the fourth photomask are placed over the planar layout of the completed semiconductor integrated circuit device 1 illustrated in FIG. 1.

As illustrated in FIG. 9, the resists Rm4a and Rm4b are dedicated to fabrication of the memory circuit region ER1. Thus, the resist Rm4a covers the entire surface of the peripheral circuit region ER2, whereas the resist Rm4b covers only portions of the gate-contact cutout regions ER12 and ER13 of the memory circuit region ER1 where the contact formation conductive layers 10a, 11a, 10b, and 11b are to be formed.

Then, the conductive layer 37 (FIG. 8) which has been exposed in the memory circuit region ER1 is etched back while the resist Rm4a covers the entire surface of the peripheral circuit region ER2 and the resist Rm4b covers portions of the gate-contact cutout regions ER12 and ER13 of the memory circuit region ER1 where the contact formation conductive layers 10a, 11a, 10b, and 11b are to be formed.

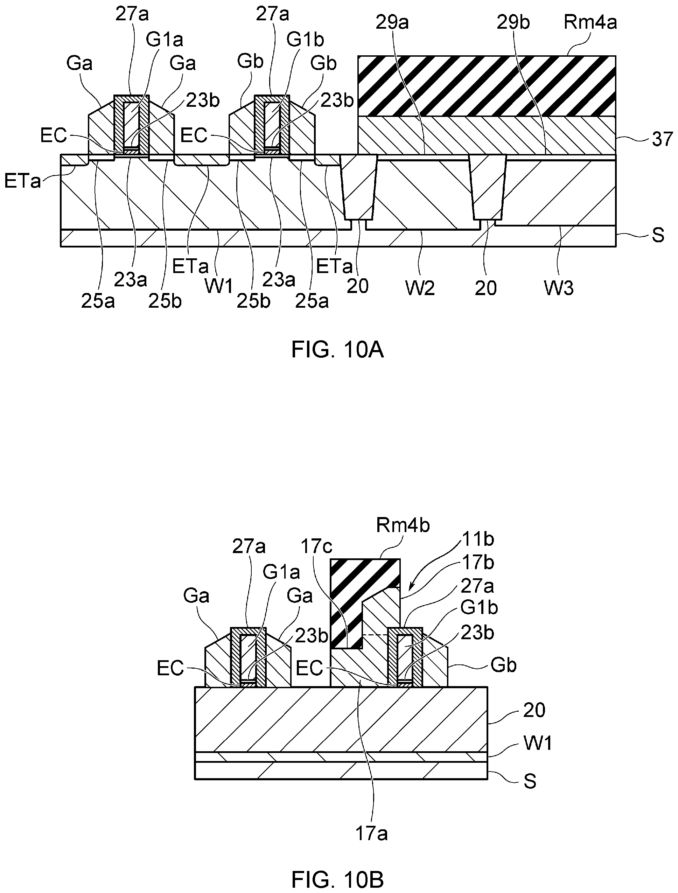

Accordingly, as illustrated in FIG. 10A, in which any corresponding part to that in FIG. 8 is denoted by an identical reference numeral, the conductive layer 37 being covered by the resist Rm4a remains intact in the peripheral circuit region ER2. The conductive layer 37 being exposed is etched back in the memory circuit region ER1. Thus, sidewall-shaped surrounding conductive layers Ga and Gb are respectively formed along the sidewall spacer 27a on the sidewall of the memory gate structures 4a and 4b.

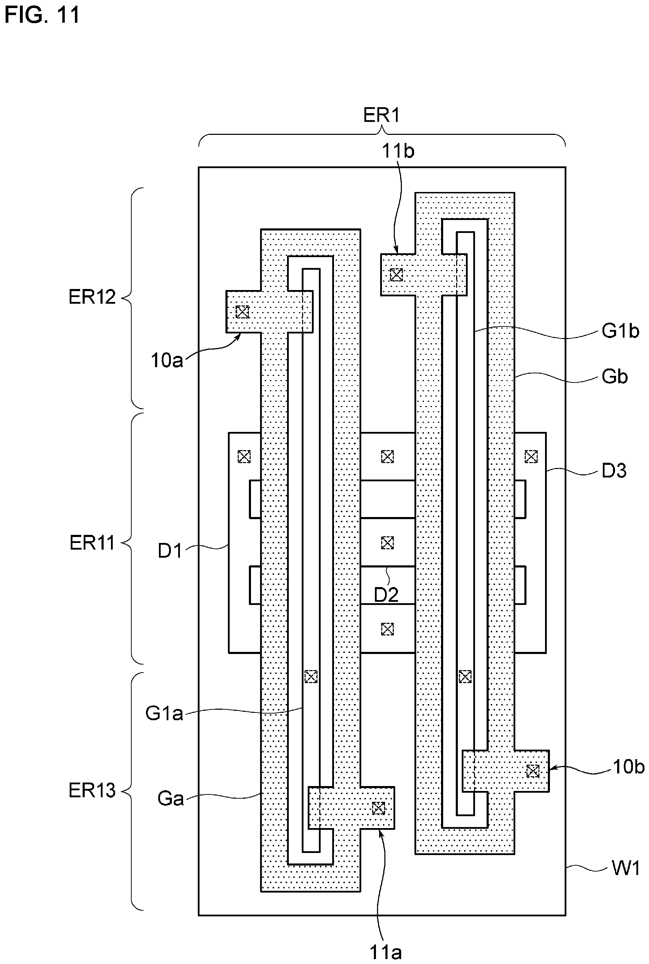

FIG. 11 is a schematic view illustrating a state in which the surrounding conductive layers Ga and Gb formed around the memory gate structures 4a and 4b are placed over a planar layout of the memory circuit region ER1 of the completed semiconductor integrated circuit device 1 illustrated in FIG. 1. In the present embodiment, as illustrated in FIG. 11, the memory gate electrodes G1a and G1b are formed linearly, and thus the surrounding conductive layers Ga and Gb have oval shapes (long circle shapes) in accordance with the outline shapes of the memory gate electrodes G1a and G1b each extending in one direction. The surrounding conductive layers Ga and Gb have shapes surrounding the respective memory gate electrodes G1a and G1b.

In addition, with the use of the resist Rm4b (FIG. 9) formed in the memory circuit region ER1, the conductive layer 37 which is disposed on and around a part of the memory gate electrode G1a (G1b) in the memory circuit region ER1 remains intact. Thus, as illustrated in FIG. 11, the contact formation conductive layers 10a and 11a (10b and 11b) are formed on the surrounding conductive layer Ga (Gb) in the memory circuit region ER1. Since the contact formation conductive layers 10a, 11a, 10b, and 11b have identical configurations, the following description will be made on the contact formation conductive layer 11b disposed in a region including line B-B' in FIG. 9.

As illustrated in FIG. 10B, which illustrates a cross section taken along line B-B' in FIG. 9, the base 17a disposed on the element isolation layer 20 and the mounting portion 17b on part of the top portion of the memory gate electrode G1b are formed integrally in the contact formation conductive layer 11b. The contact installation surface 17c, which has a flat shape in accordance with the surface shape of the element isolation layer 20, is formed on the base 17a.

In this step, the conductive layer 37 in the memory circuit region ER1 is processed to form the sidewall-shaped surrounding conductive layers Ga and Gb along the sidewall spacers 27a on the sidewalls of the memory gate structures 4a and 4b in the memory circuit region ER1. Simultaneously, the contact formation conductive layers 10a, 11a, 10b, and 11b are formed on the surrounding conductive layers Ga and Gb.

Subsequently, for example, the ion implantation technique is employed to implant low concentration of N-type impurities into the memory circuit region ER1 not being covered by the resist Rm4b. Accordingly, an extension region ETa is formed on the surface of the memory well W1, which has been externally exposed, and thereafter, the resists Rm4a and Rm4b are removed.

Subsequently, in the present invention, a resist is patterned by the photolithography technique and the etching technique using a photomask (not illustrated), and the conductive layer 37 in the peripheral circuit region ER2 is patterned by using the resist to form the logic gate electrodes G5 and G6 on the gate insulating films 29a and 29b. Simultaneously, part of the surrounding conductive layers Ga and Gb in the memory circuit region ER1 is removed by using the same resist used to form the logic gate electrodes G5 and G6.

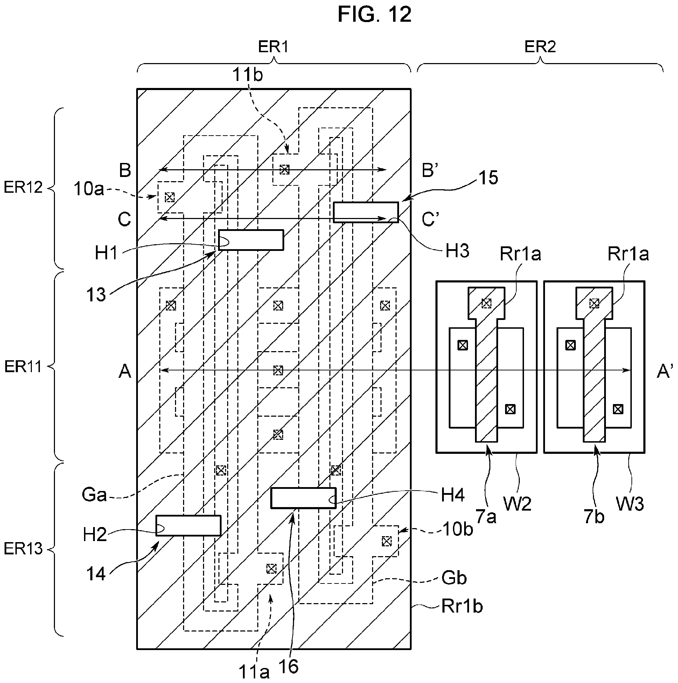

FIG. 12 is a schematic view illustrating a state in which resists Rr1a and Rr1b formed in the above-described step are placed over the planar layout of the completed semiconductor integrated circuit device 1 illustrated in FIG. 1. In the present embodiment, as illustrated in FIG. 12, the resist Rr1a is disposed on portions of the peripheral circuit region ER2 where the logic gate structures 7a and 7b are to be formed. The resist Rr1a is formed in accordance with the outline shapes of the logic gate structures 7a and 7b, which are to be formed later. The resist Rr1b covers substantially the entire surface of the memory circuit region ER1, but includes the openings H1, H2, H3, and H4 where the select gate electrode cutout portions 13, 14, 15, and 16 are to be formed. The openings H1, H2, H3, and H4 are formed in accordance with the outline shapes of the select gate electrode cutout portions 13, 14, 15, and 16, which are to be formed later.

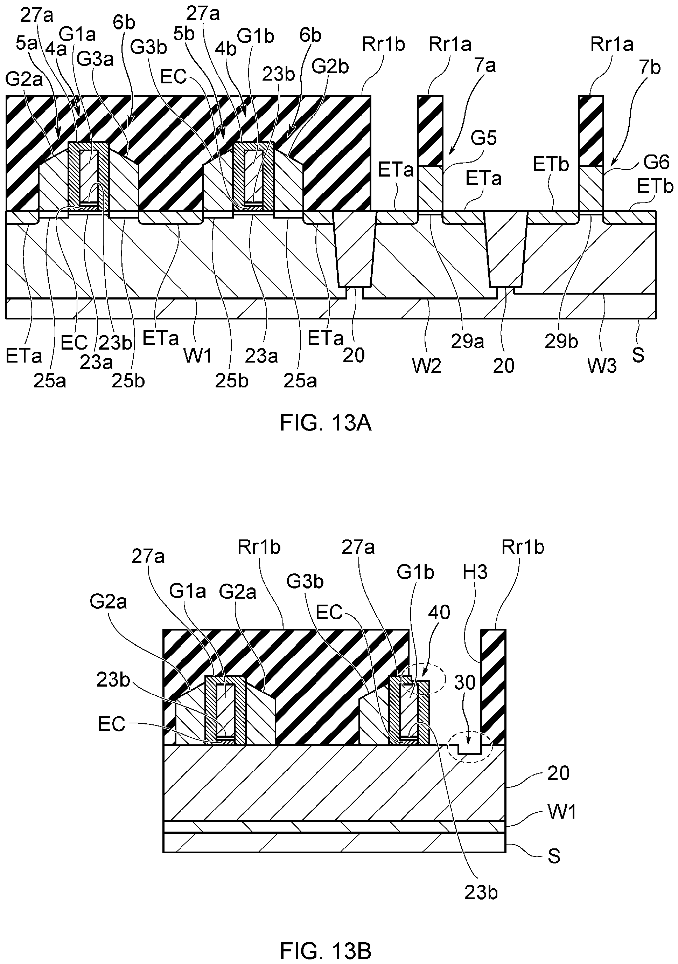

In the peripheral circuit region ER2, the conductive layer 37 being externally exposed is removed, whereas only the conductive layer 37 being covered by the resist Rr1a remains. Accordingly, as illustrated in FIG. 13A, in which any corresponding part to that in FIG. 10A is denoted by an identical reference numeral, in the peripheral circuit region ER2, the logic gate electrodes G5 and G6 are formed in accordance with the outline shape of the resist Rr1a. The logic gate structures 7a and 7b, in which the logic gate electrodes G5 and G6 are stacked on the gate insulating films 29a and 29b, are formed, respectively.

At this time, as illustrated in FIG. 13B, which illustrates a cross section taken along line C-C' in FIG. 12, in the memory circuit region ER1, the surrounding conductive layer Gb being exposed through the opening H3 of the resist Rr1b is removed to form, on the element isolation layer 20, the select gate electrode cutout portion 15, from which the surrounding conductive layer Gb is removed in accordance with the outline shape of the opening H3 of the resist Rr1b.

Accordingly, in the memory circuit region ER1, a plurality of portions of the surrounding conductive layer Ga (Gb) are removed from the surrounding conductive layer Ga (Gb) so that the surrounding conductive layer Ga (Gb) is divided into the first select gate electrode G2a (G2b), which is continuous with the contact formation conductive layer 10a (10b), and the second select gate electrode G3a (G3b), which is continuous with the contact formation conductive layer 11a (11b). In addition, the first select gate structure 5a (5b), in which the first select gate electrode G2a (G2b) is disposed on the gate insulating film 25a, and the second select gate structure 6a (6b), in which the second select gate electrode G3a (G3b) is disposed on the gate insulating film 25b, are formed in the memory circuit region ER1.

In addition to the second select gate electrode G3b to be removed, the sidewall spacer 27a and the element isolation layer 20 are exposed through the opening H3 of the resist Rr1b. Thus, a part of the sidewall spacer 27a and a part of the element isolation layer 20 being exposed through the opening H3 of the resist Rr1b are removed through the above-described step. Accordingly, in a region exposed through the opening H3, the sidewall spacer 27a is removed, leaving a chipped portion 40 near a top portion of the sidewall spacer 27a. A part of the surface of the element isolation layer 20 is removed, leaving the recess 30 in the element isolation layer 20.

Then, after the resists Rr1a and Rr1b are removed by, for example, ashing, a resist patterned for an N type or a P type is used to implant low concentration of N-type impurities or P-type impurities into the peripheral circuit region ER2 by, for example, the ion implantation technique. Accordingly, as illustrated in FIG. 13A (FIG. 13A illustrates the resists Rr1a and Rr1b, which are supposed to be removed in this step), the N-type extension region ETa is formed on the substrate surface on the logic well W2 being externally exposed, whereas a P-type extension region ETb is formed on the substrate surface on the logic well W3 being externally exposed.

Lastly, the resist is removed, followed by a step of forming the sidewall structure SW, a step of forming the source regions D1 and D3 and the drain regions D2 by implanting high concentration of N-type impurities or P-type impurities into necessary places by, for example, the ion implantation technique, a step of forming the silicide SC, and a step of forming, for example, the insulating layer 21 and the contacts C1, C2, C3, and so forth. The semiconductor integrated circuit device 1 having the configuration illustrated in FIGs. 1, 2, 3, and 4 is produced by sequentially performing the above steps.

(3) Operations and effects

In the method for producing the semiconductor integrated circuit device 1 as described above, the layered gate insulating films 25a, 25b, 25c, 29a, and 29b and the layered conductive layer 37 are stacked in this order in the memory circuit region ER1 (FIG. 7A) including the memory gate structures 4a and 4b, which are covered by the sidewall spacers 27a, and the peripheral circuit region ER2 (FIG. 8). Then, the conductive layer 37 in the memory circuit region ER1 is etched back while leaving intact the conductive layer 37 in the peripheral circuit region ER2 and the conductive layer 37 around part of the memory gate structures 4a and 4b in the memory circuit region ER1.

Accordingly, in the method for producing the semiconductor integrated circuit device 1, the sidewall-shaped surrounding conductive layers Ga and Gb are formed around the memory gate structures 4a and 4b through the sidewall spacers 27a, respectively, and the contact formation conductive layers 10a, 11a, 10b, and 11b, which remain to cover parts of the memory gate structures 4a and 4b, are formed (FIGS. 9 to 11).

In addition, in the method for producing the semiconductor integrated circuit device 1, the conductive layer 37 in the peripheral circuit region ER2 is patterned by using the resist Rr1a patterned by using a photomask. Thereby, the logic gate electrodes G5 and G6 are formed on the gate insulating films 29a and 29b. Then, by using the resists Rr1a and Rr1b, which are used to form the logic gate electrodes G5 and G6, parts of the surrounding conductive layers Ga and Gb in the memory circuit region ER1 are removed. Thereby, each of the surrounding conductive layers Ga and Gb is separated.

Accordingly, the method for producing the semiconductor integrated circuit device 1 forms the first select gate electrode G2a (G2b) and the second select gate electrode G3a (G3b) (FIGs. 12 and 13). The first select gate electrode G2a (G2b) is continuous with the contact formation conductive layer 10a (10b). The second select gate electrode G3a (G3b) is electrically separated from the first select gate electrode G2a (G2b) and continuous with the contact formation conductive layer 11a (11b).

As a result, in the semiconductor integrated circuit device 1, the peripheral circuit region ER2 includes the logic gate electrodes G5 and G6 made of a conductive layer the same as that of the first select gate electrode G2a (G2b) and the second select gate electrode G3a (G3b). In addition, the memory circuit region ER1 includes the sidewall-shaped first select gate electrode G2a (G2b) and the sidewall-shaped second select gate electrode G3a (G3b), which are disposed along one virtual line surrounding the memory gate electrode G1a (G1b) and are electrically separated from each other by the select gate electrode cutout portions 13 and 14 (15 and 16).

As described above, in the present invention, during a photomask process of forming the logic gate electrodes G5 and G6 in the peripheral circuit region ER2, the surrounding conductive layer Ga (Gb) in the memory circuit region ER1 is divided into the first select gate electrode G2a (G2b) and the second select gate electrode G3a (G3b) electrically separated from each other. Thus, the first select gate electrodes G2a and G2b and the second select gate electrodes G3a and G3b, which are separately controllable, are formed without performing an extra dedicated photomask process of fabricating only the memory circuit region ER1 in addition to conventional dedicated photomask process of fabricating only a memory circuit region. Thereby, production cost is reduced.

In the method for producing the semiconductor integrated circuit device 1, a dedicated photomask process of patterning a resist by using at least one photomask dedicated to fabrication of the memory circuit region ER1 includes a total of four steps: (i) the first photomask processing step (FIG. 5B) of forming a channel formation layer by implanting impurities into portions of the substrate surface where the memory gate structures 4a and 4b are to be formed, and removing the sacrificial oxide film 30a in the memory circuit region ER1, (ii) the second photomask processing step (FIG. 6A) of forming the memory gate electrodes G1a and G1b by patterning the memory gate electrode conductive layer 35, (iii) the third photomask processing step (FIG. 7B) of forming a channel formation layer by implanting impurities to portions where the first select gate electrodes G2a and G2b and the second select gate electrodes G3a and G3b are to be formed, and (iv) the fourth photomask processing step (contact formation photomask processing step (FIGS. 10A and 10B)) of forming the surrounding conductive layers Ga and Gb and the contact formation conductive layers 10a, 11a, 10b, and 11b in the memory circuit region ER1.

Accordingly, in the method of producing the semiconductor integrated circuit device 1, an extra production process corresponding to four photomasks in addition to a typical process of producing a peripheral circuit allows incorporation of the memory cells 3a, 3c, 3e, 3b, 3d, and 3f, in which the first select gate electrode G2a (G2b) and the second select gate electrode G3a (G3b) disposed with the memory gate electrode G1a (G1b) therebetween are separately controllable. Thereby, cost is reduced.

(4) Production methods according to other embodiments without third photomask processing step

In the above-described embodiment, the dedicated photomask process of patterning a resist by using at least one photomask dedicated to fabrication of the memory circuit region ER1 includes a total of four steps: the first photomask processing step, the second photomask processing step, the third photomask processing step, and the fourth photomask processing step for a contact formation conductive layer. However, the present invention is not limited thereto. The dedicated photomask process may include a total of three steps: the first photomask processing step, the second photomask processing step, and the contact formation photomask processing step (corresponding to the above-described fourth photomask processing step), without the impurity implantation in the third photomask processing step.

In other words, it is not necessary to perform the third photomask processing step in a case in which each of the completed first select gate structures 5a and 5b and second select gate structures 6a and 6b achieves a desired threshold voltage (Vth) without the impurity implantation in the third photomask processing step. In that case, the third photomask processing step may be omitted.

In such a production method without the third photomask processing step, the sidewall spacers 27a covering the memory gate structures 4a and 4b (FIG. 6B) are formed as illustrated in FIG. 7A (sidewall spacer formation step). Then, the sacrificial oxide film 30a in the peripheral circuit region ER2 is removed by using, for example, hydrofluoric acid. Thereafter, as illustrated in FIG. 7C, for example, the thermal oxidation method is employed to form the gate insulating films 25a and 25b on the portions of the memory circuit region ER1 where the first select gate electrode G2a and G2b (FIG. 1) and the second select gate electrodes G3a and G3b (FIG. 1) are to be formed. The thermal oxidation method is also employed to form the gate insulating films 29a and 29b on the portions of the peripheral circuit region ER2 where the logic gate electrodes G5 and G6 (FIG. 1) are to be formed. Then, similar to the production method of the above-described embodiment, the semiconductor integrated circuit device 1 illustrated in FIG. 1 is produced through the production steps illustrated in FIGS. 8 to 12.

In the present embodiment without the third photomask processing step, the memory cells 3a, 3b, 3c, 3d, 3e, and 3f are incorporated through the production process, in which only the steps corresponding to the three photomasks are performed in addition to a typical process for producing the peripheral-circuit. In the memory cells 3a, 3b, 3c, 3d, 3e, and 3f, the first select gate electrode G2a and G2b and the second select gate electrodes G3a and G3b are formed to sandwich the memory gate electrodes G1a and G1b, and are separately controlled. Thus, the production method without the third photomask processing step uses a reduced number of photomasks as compared to the production method of the above-described embodiment, resulting in cost reduction.

(5) Other embodiments

The present invention is not limited to the present embodiment, but various modifications are possible within the scope of the present invention. For example, the number of the memory cells 3a, 3b, 3c, 3d, 3e, and 3f, the number of the peripheral circuits 18 and 19, the number of the contact formation conductive layers 10a, 11a, 10b, and 11b, and the number of the select gate electrode cutout portions 13, 14, 15, and 16 may be any other numbers. The conductivity types of the memory well W1, and the logic wells W2 and W3 may be of any one of the N type or the P type.

In the above-described embodiment, for example, the contact formation conductive layers 10a and 11a of the first column and the select gate electrode cutout portions 13 and 14 may be disposed at any positions to allow the first select gate electrode G2a continuous with the contact formation conductive layer 10a and the second select gate electrode G3a continuous with the contact formation conductive layer 11a to be electrically separated from each other to achieve separate control of the first select gate electrode G2a and the second select gate electrode G3a.

For example, the select gate electrode cutout portions 13, 14, 15, and 16 may be disposed at four corners of the rectangular surrounding conductive layer Ga. In this case, the end of the first select gate electrode G2a and the end of the second select gate electrode G3a are not disposed along one straight line, but orthogonally disposed at a predetermined distance therebetween.

For example, in the memory circuit region ER1 of the semiconductor integrated circuit device 1 illustrated in FIG. 1, the single contact formation conductive layer 10a and the single select gate electrode cutout portion 13 are provided in the gate-contact cutout region ER12, and the single contact formation conductive layer 11a and the single select gate electrode cutout portion 14 are provided in the gate-contact cutout region ER13. However, the present invention is not limited thereto. The two contact formation conductive layers 10a and 11a may be provided in the gate-contact cutout region ER12, the single select gate electrode cutout portion 13 may be disposed between the two contact formation conductive layers 10a and 11a, and the single select gate electrode cutout portion 14 may be provided in the gate-contact cutout region ER13.

With this configuration, the first select gate electrode G2a continuous with the contact formation conductive layer 10a and the second select gate electrode G3a continuous with the contact formation conductive layer 11a are electrically separated from each other to allow separate control of the first select gate electrode G2a and the second select gate electrode G3a.

In other words, in the method for producing a semiconductor integrated circuit device of the present invention, when the surrounding conductive layer Ga is provided with the two or more contact formation conductive layers 10a, 11a, ..., the select gate electrode cutout portions 13, 14, ... may be disposed at the positions where select gate electrodes provided continuously with the contact formation conductive layers 10a, 11a, ... are electrically separated from each other.

In the above-described embodiment, the peripheral circuits 18 and 19 may be other various peripheral circuits (direct peripheral circuits) such as a sense amplifier, a column decoder, and a row decoder disposed in the same area as that of the memory cells 3a, 3b, 3c, 3d, 3e, and 3f. The peripheral circuits 18 and 19 may be other various peripheral circuits, such as a CPU, an ASIC, and an input and output circuit, which are disposed in an area different from that of the memory cells 3a, 3b, 3c, 3d, 3e, and 3f.

Reference Sings List

1 semiconductor integrated circuit device
3a, 3b, 3c, 3d, 3e, 3f memory cell
4a, 4b memory gate structure
5a, 5b first select gate structure
6a, 6b second select gate structure
G1a, G1b memory gate electrode
G2a, G2b first select gate electrode
G3a, G3b second select gate electrode
EC charge storage layer
23a lower gate insulating film
23b upper gate insulating film
Rr1a, Rr1b resist

## Claims

1. A semiconductor integrated circuit device (1) comprising:

    a memory circuit region (ER1) including a memory cell (3a, 3b, 3c, 3d, 3e, 3f) in a memory cell region (ER11) in which a memory gate structure (4a, 4b) , a first select gate structure (5a, 5b) and a second select gate structure (6a, 6b) are disposed between a source region (D1, D3) and a drain region (D2), the memory gate structure being disposed between the first select gate structure (5a, 5b) and the second select gate structure (6a, 6b) through a sidewall spacer (27a), the first select gate structure including a first select gate electrode (G2a, G2b), the second select gate structure including a second select gate electrode (G3a, G3b);
    a peripheral circuit region (ER2) including a logic gate structure (7a, 7b) of a peripheral circuit,
    wherein the logic gate structure has a configuration in which a logic gate electrode (G5, G6) made of a conductive layer (37) same as a conductive layer (37) of the first select gate electrode and the second select gate electrode is disposed on a gate insulating film (29a, 29b),
    the memory gate structure has a configuration in which a lower gate insulating film (23a), a charge storage layer (EC), an upper gate insulating film (23b), and a memory gate electrode (G1a, G1b) are stacked in this order,
    the first select gate structure (5a, 5b) has a configuration in which the first select gate electrode (G2a, G2b) is disposed on a gate insulating film (25a), and the second select gate structure (6a, 6b) has a configuration in which the second select gate electrode (G3a, G3b) is disposed on a gate insulating film (25b), and
    the first select gate electrode and the second select gate electrode are sidewall-shaped along the sidewall spacer on a sidewall of the memory gate electrode, and disposed along one line surrounding the memory gate electrode, and
    on gate-contact cutout regions (ER12, ER13) between which the memory cell region (ER11) is disposed, an end of the first select gate electrode and an end of the second select gate electrode face each other at a predetermined distance and are disposed along one straight line.

2. The semiconductor integrated circuit device according to claim 1, wherein

    a first contact formation conductive layer (10a) is disposed on the first select gate electrode, and

a second contact formation conductive layer (11a) is disposed on the second select gate electrode.

FIG. 1

FIG. 2

FIG. 3

FIG. 4

MEMORY CIRCUIT REGION | PERIPHERAL CIRCUIT REGION

ER1    30a                ER2

                                                        S

20    W2    20    W3

FIG. 5A

Rm1

30a

W1    20    W2    20    W3                               S

FIG. 5B

EC  23b  35  30b                                30a

23a  W1            20    W2    20    W3          S

FIG. 5C

FIG. 6A

FIG. 6B

FIG. 6C

FIG. 7A

FIG. 7B

FIG. 7C

FIG. 8

FIG. 9

EP 4 235 802 A2

FIG. 10A

FIG. 10B

FIG. 11

# FIG. 12

FIG. 13A

FIG. 13B

**EP 4 235 802 A2**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011129816 A